## Europäisches Patentamt

## European Patent Office

## Office européen des brevets

(19)

(11) Veröffentlichungsnummer: **0 172 345 B1**

(12) # EUROPÄISCHE PATENTSCHRIFT

(45) Veröffentlichungstag der Patentschrift: **10.05.89**

(21) Anmeldenummer: **85107337.9**

(22) Anmeldetag: **13.06.85**

(51) Int. Cl.⁴: **G 01 N 24/08,** A 61 B 5/05

(54) **Gerät zur Erzeugung von Bildern eines Untersuchungsobjektes.**

(30) Priorität: **01.08.84 DE 3428391**

(43) Veröffentlichungstag der Anmeldung:
**26.02.86 Patentblatt 86/9**

(45) Bekanntmachung des Hinweises auf die Patenterteilung:
**10.05.89 Patentblatt 89/19**

(84) Benannte Vertragsstaaten:
**DE FR GB NL**

(56) Entgegenhaltungen:
EP-A-0 093 897
EP-A-0 096 487
DE-A-2 854 774

**SCIENTIFIC AMERICAN, Band 246, Nr. 5, Mai 1982, Seiten 54-64, New York, US; I.L. PYKETT: "NMR imaging in medicine"**
**AMERICAN JOURNAL OF RADIOLOGY, Band 143, Dezember 1984, Seiten 1175-1182, New York, US; R.L. EHMAN et al.: "Magnetic resonance imaging with respiratory gating: techniques and advantages"**

(73) Patentinhaber: **Siemens Aktiengesellschaft Berlin und München, Wittelsbacherplatz 2, D-8000 München 2 (DE)**

(72) Erfinder: **Stetter, Eckart, Dr., Steinforststrasse 27, D-8520 Erlangen (DE)**
Erfinder: **Reichenberger, Helmut, Dr., Begonienstrasse 28, D-8521 Eckental (DE)**
Erfinder: **Schneider, Siegfried, Dr., Kulmbacher Strasse 33, D-8520 Erlangen (DE)**
Erfinder: **Wirth, Axel, Siemensstrasse 39, D-8500 Nürnberg 40 (DE)**

## Beschreibung

Die Erfindung betrifft ein Gerät zur Erzeugung von Bildern eines Untersuchungsobjektes mit magnetischer Kernresonanz, bei dem Mittel zum Anlegen von magnetischen Grund- und Gradientenfeldern an das Untersuchungsobjekt und zum Erfassen der Auslenkung der Kernspins des Untersuchungsobjektes aus ihrer Gleichgewichtslage durch einen hochfrequenten magnetischen Anregungsimpuls vorhanden sind, wobei bei einer Vielzahl von Gradienten in einer Schicht des Untersuchungsobjektes jeweils eine Projektion der Kernspins auf eine Frequenzachse als Fourierzeile erfaßt und aus den Fourierzeilen ein Bild der jeweils untersuchten Schicht durch Fouriertransformation berechnet wird und wobei Mittel zur Steuerung der Erfassung der Fourierzeilen in Abhängigkeit von einem Bewegungssignal einer Organbewegung vorgesehen sind.

Es ist bekannt, daß man insbesondere die Wasserstoffkernspins eines Untersuchungsobjektes aus einer Vorzugsrichtung, die durch ein Magnet-Grundfeld erzeugt wird, durch einen hochfrequenten Anregungsimpuls auslenken kann und daß sich diese Spins nach dem Ende dieses Anregungsimpulses erst nach einer gewissen Zeit wieder in die Vorzugsrichtung einpendeln. Während dieser Zeit präzedieren die Spins mit einer Frequenz, die von der Stärke des Magnet-Grundfeldes abhängt. Diese Präzessionsbewegung kann mit einer HF-Antenne und entsprechenden Empfängerschaltungen detektiert werden. Überlagert man diesem homogenen Magnet-Grundfeld einen ersten Feldgradienten, so daß die Magnetfeldverteilung räumlich variiert, so ist eine Ortung der Spins in einer Raumrichtung, nämlich der Gradientenrichtung über die jeweils gemessene Frequenz möglich

Es ist auch bekannt, daß man durch kurzzeitiges Anlegen eines zum ersten Gradienten orthogonalen zweiten Gradienten variabler Amplitude oder Zeitdauer eine Ortskodierung in einer zweiten Raumachse vornehmen kann, bevor die Signale im ersten Gradienten ausgelesen werden und man auf diese Weise Schichtbilder eines Untersuchungsobjektes anfertigen kann. Die Anregung in einer Schicht des Untersuchungsobjektes erfolgt dabei dadurch, daß das Magnet-Grundfeld durch einen weiteren dritten Feldgradienten senkrecht zum ersten und zweiten Gradienten so beeinflußt wird, daß nur in dieser Schicht eine Anregung der Spins erfolgt. Dies ist möglich, weil die Anregung nur mit einer Frequenz erfolgt, die dem Magnetfeld in der gewünschten Schicht streng zugeordnet ist. Dieses Verfahren ist z. B. in der DE-OS-2 611 497 beschrieben.

Aufgrund der Vielzahl der erforderlichen Meßvorgänge dauert eine vollständige Messung für eine Schicht so lange, daß sich Bewegungen im Untersuchungsobjekt, beispielsweise Bewegungen aufgrund des Herzschlages oder der Atmung als Störungen im erzeugten Bild zeigen würden. Zur Vermeidung solcher Störungen ist es z. B. aus der Zeitschrift "Radiology, Volume 151, Nr. 2, Mai 1984, Seiten 521 - 523" bekannt, die Meßwerterfassung in Abhängigkeit vom EKG und von der jeweiligen Meßwerterfassung nur in einem relativ kurzen Zeitbereich jeder Atemphase freizugeben. Dadurch ergibt sich eine erhebliche Verlängerung der Meßzeit, die in der Praxis nicht immer akzeptierbar ist.

In der DE-A-2 854 774 wird eine Vorrichtung zur Untersuchung von Körpergewebe auf der Basis der Spin-Echo-Technik beschrieben. Die Kompensation von Unschärfeeffekten, hervorgerufen durch periodische Bewegungen des zu untersuchenden Objektes (z. B. Herzschlag, Atembewegungen) erfolgt durch eine Vermessung der zeitlichen Bewegung mindestens zweier anatomisch ausgezeichneter Referenzpunkte und durch die aufgrund dieser Information eingeleiteten Korrekturmaßnahmen (Interpolation auf vorgewählter Zeit, Nachführung). Eine Beschränkung der bewegungsgetriggerten Meßsignalerfassung auf einen bestimmten Fourier-Zeilenbereich wird nicht angesprochen.

Der Erfindung liegt die Aufgabe zugrunde, ein Gerät der eingangs genannten Art so auszubilden, daß durch Organbewegungen erzeugte Bewegungsartefakte im Bild auf ein Minimum reduziert sind, wobei die Meßzeit gegenüber dem Stand der Technik erheblich verkleinert ist.

Diese Aufgabe ist in einer ersten Ausführungsform erfindungsgemäß gelöst durch einen Zeilenzähler, der Schaltmittel für die Steuerung der Meßsignalerfassung derart ansteuert, daß die Meßsignalerfassung für alle Zeilen außerhalb eines vorbestimmten Bereiches immer, innerhalb dieses Bereiches jedoch in Abhängigkeit vom Bewegungssignal freigegeben wird. Bei dem erfindungsgemäßen Gerät werden z. B. atmungsbedingte Bewegungsartefakte durch geeignete Steuerung der Meßsignalerfassung (Atemgating) um die Fourier-Nullzeile, die definiert ist durch das Fehlen des die zweite Raumachse kodierenden Gradienten, und dauernde Freigabe der Meßwerterfassung bei entfernteren Zeilen praktisch vollständig unterdrückt.

In einer zweiten Ausführungsform ist die Aufgabe erfindungsgemäß gelöst durch einen Zeilenzähler, der Schaltmittel für die Steuerung der Meßsignalerfassung derart ansteuert, daß die Meßsignalerfassung für alle Zeiten außerhalb eines vorbestimmten Bereiches abgeschaltet und als Meßsignal ein synthetischer Wert verwendet wird und daß die Meßsignalerfassung innerhalb dieses Bereiches in Abhängigkeit von dem Bewegungssignal freigegeben wird.

Durch diese Maßnahme wird die Meßzeit derjenigen Fourier-Zeilen eingespart, die durch die Bereichswahl außerhalb desselben liegen. Die durch das Einsetzen des Meßwertes "Null" bedingte Unschärfe des Bildes geht in der ohnehin noch durch die Organbewegung verursachten Unschärfe unter, so daß im Bildbereich des Organs keine Qualitätsminderung auftritt.

Die Erfindung ist nachfolgend anhand der Zeichnung näher erläutert. Es zeigen:

Fig. 1 eine Darstellung eines Gerätes nach der Erfindung gemäß der ersten Ausführungsform, und

Fig. 2 bis 5 Darstellungen zur Erläuterung der Wirkungsweise des Gerätes gemäß Figur 1.

Fig. 6 eine Darstellung eines Gerätes nach der Erfindung gemäß der zweiten Ausführungsform.

Fig. 7 eine schematische Darstellung einer Zeilenmatrix gemäß der zweiten Ausführungsform.

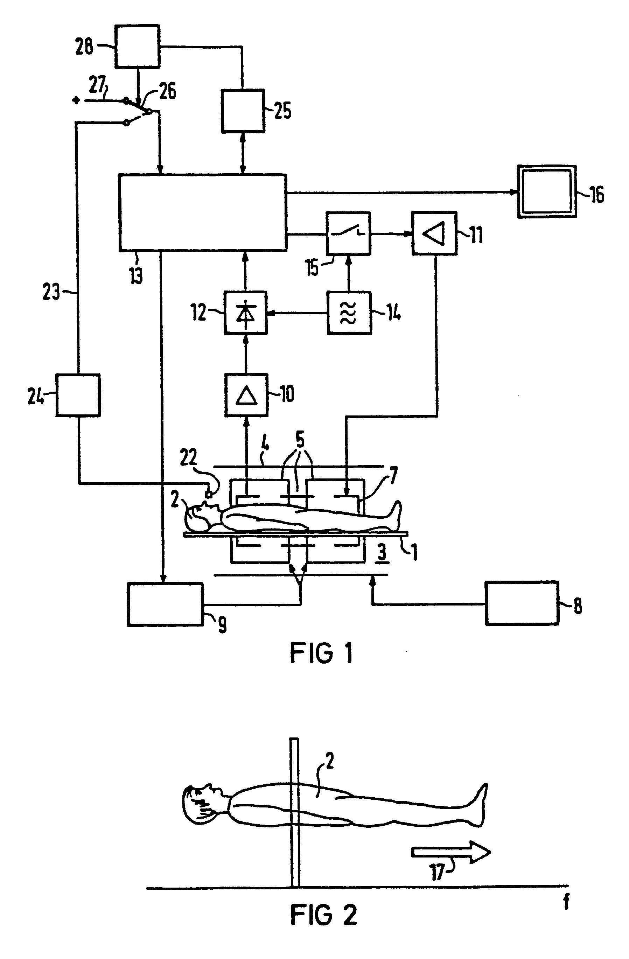

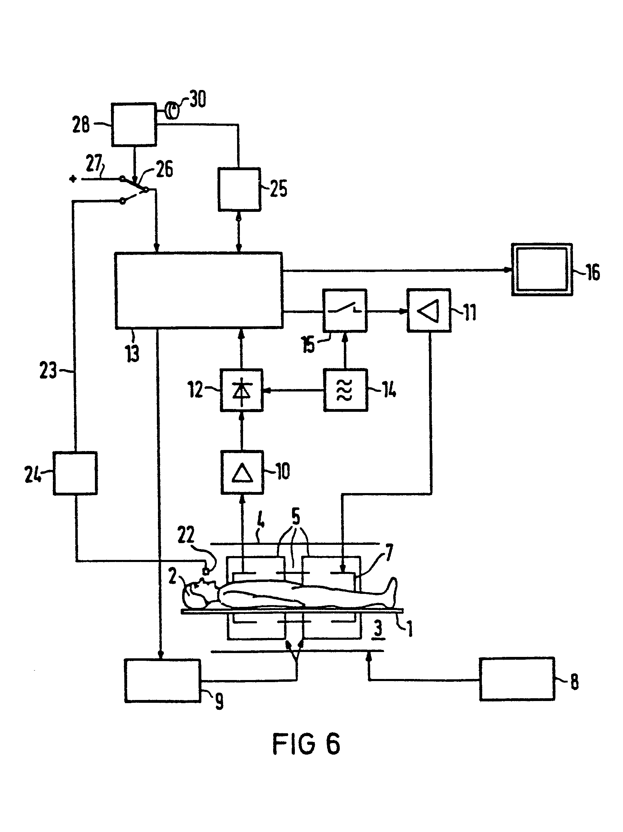

In der Figur 1 und 6 ist eine Auflage 1 dargestellt, auf der ein Patient 2 liegt, von dem mit Hilfe magnetischer Kernresonanz Bilder erzeugt werden sollen. Hierzu ist ein Spulensystem 3 mit einer Spule 4 zur Erzeugung eines homogenen Magnet-Grundfeldes, Gradientenspulen 5 zur Variierung dieses Magnet-Grundfeldes sowie mit einer Anregungs- und Meßspule 7 vorhanden. Die Spule 4 ist an einer Magnetstromversorgung 8, die Gradientenspulen 5 sind an einer Gradienten-Stromversorgung 9, die Anregungs- und Meßspule 7 ist an einem Vorverstärker 10 und über entsprechende Koppelelemente an einen Sendeverstärker 11 angeschlossen. Der Vorverstärker 10 führt das Meßsignal über einen phasenempfindlichen Gleichrichter 12 einem Prozeßrechner 13 zu, der den gesamten Meßvorgang steuert. Zur Erzeugung eines Anregungsimpulses dient ein Hochfrequenzoszillator 14, der über einen Modulator 15 an den Sendeverstärker 11 anschaltbar ist. Die Wiedergabe der aus den Meßsignalen rekonstruierten Bilder erfolgt auf einem Monitor 16.

Zur Erzeugung eines Schichtbildes von dem im Spulensystem 3 gelagerten Patienten 2 werden zunächst die Spins in der gewünschten Schicht angeregt.

Die Figur 2 zeigt, daß die jeweils angeregte Schicht im Patienten 2 von der Ortsabhängigkeit der Flußdichte und damit der Kernresonanzfrequenz bestimmt wird. Der Feldgradient für das Grundfeld ist in der Figur 2 schematisch dargestellt und mit 17 bezeichnet. Die Resonanzfrequenz ist mit f bezeichnet. Es erfolgt dabei nur eine Anregung der Spins im dargestellten Bereich des Patienten 2.

Nach der Anregung erfolgt die Kodierung der Spins in der (wie oben) bezeichneten zweiten Raumachse durch Anlegen eines kurzzeitigen Gradienten in der zweiten Raumrichtung, im folgenden Kodiergradient genannt. Anschließend wird das Kernresonanzsignal in dem die erste Raumdimension definierenden sogenannten Auslesegradienten abgetastet. Dieser Vorgang wird z. B. mit schrittweise von positiv nach negativ verändertem Kodiergradienten wiederholt. Die zu einer bestimmten Kodiergradientenamplitude ausgelesenen Kernresonanzsignale kann man als Fourierprojektion bezeichnen.

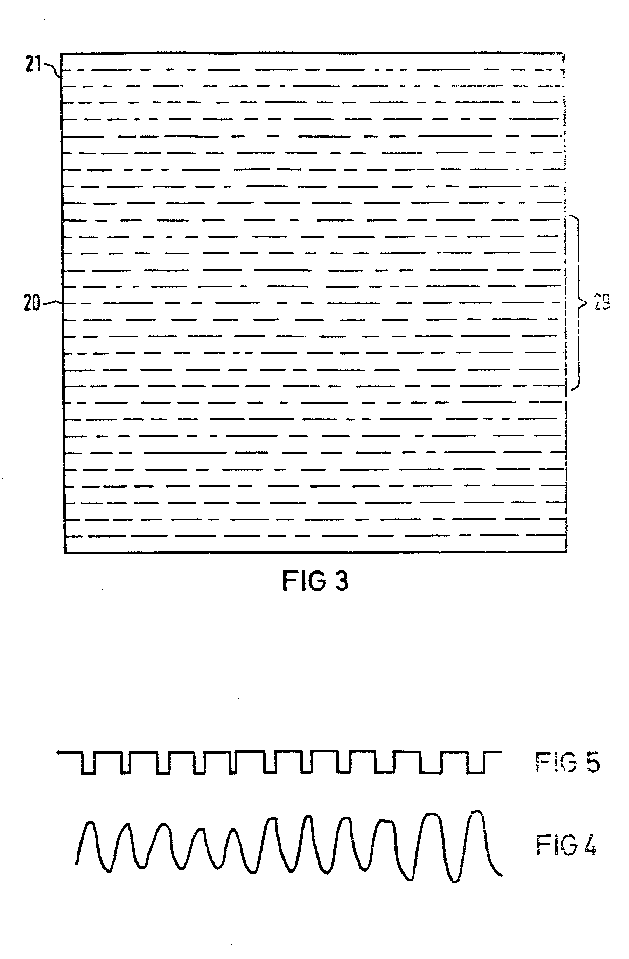

Die den aufeinanderfolgenden Fourierprojektionen entsprechenden Meßsignale entsprechen parallelen Fourierzeilen der in der Figur 3 dargestellten Meßmatrix. In der Praxis können beispielsweise für eine vollständige Meßmatrix 256 Fourierzeilen vorgesehen werden, wobei die Fourier-Nullzeile 20, die zum Kodiergradienten der Amplitude 0 gehört, in der Mitte der Meßmatrix 21 gemäß Figur 3 liegt. Durch zweidimensionale Fouriertransformation nach Zeilen und Spalten kann aus den Meßsignalen der einzelnen Fourierzeilen ein Bild der untersuchten Schicht berechnet werden.

Erfolgt die Meßsignalerfassung ununterbrochen, so ergeben sich störende Bewegungsartefakte im erzeugten Bild. Es ist deshalb bekannt, die Atemkurve des Patienten 2 mit einem Meßaufnehmer zu registrieren und das Atemsignal mit Hilfe einer Elektronik so aufzubereiten, daß Meßsignale nur in einem bestimmten Zeitintervall jeder Atemphase aufgenommen werden können, alle anderen Messungen, die außerhalb dieses Intervalles anfallen, werden verworfen. Um eine möglichst geringe Bewegungsunschärfe in den Bildern zu haben, muß das Zeitintervall möglichst kurz sein. Dadurch verlängert sich die Meßzeit gegenüber dem Fall der nicht atemgetriggerten Meßsignalerfassung jedoch drastisch.

Für eine Matrix mit 256 Zeilen müssen mindestens 256 Einzelaufnahmen gemacht werden. Der Kodiergradient kann bei einer atemphasengesteuerten Messung nur nach einer Messung im Frei-Zustand fortgeschaltet werden, denn die nicht im Frei-Zustand erfolgten Messungen werden verworfen.

Der ersten Ausführungsform liegt nun die Erkenntnis zugrunde, daß eine praktisch vollständige Unterdrückung von atembedingten Bewegungsartefakten im erzeugten Bild auch möglich ist, wenn ein Atemgating nur um die Fourier-Nullzeile, bei entfernteren Zeilen dagegen immer eine Freigabe der Meßsignalerfassung erfolgt. Dadurch wird die Meßzeit gegenüber dem Fall der dauernden Meßsignalerfassung nur unerheblich verlängert.

Zur atemphasengesteuerten Meßsignalerfassung ist dem Patienten 7 ein Atemdetektor 22 zugeordnet, der auf der Leitung 23 ein von einer Aufbereitungsstufe 24 erzeugtes Atemphasensignal bildet. Dieses Atemphasensignal verläuft beispielsweise gemäß Figur 4. Die Figur 5 zeigt, daß im jeweiligen Maximalbereich der Atmungskurve gemäß Figur 4 ein Freigabesignal für die Meßwerterfassung erzeugt wird.

Das Atemphasensignal bewirkt aber nicht immer die Steuerung der Meßwerterfassung entsprechend der Figur 5, sondern nur dann, wenn die Fourierzeilen innerhalb eines bestimmten ersten Bereiches um die Nullzeile 20 liegen. Dieser erste Bereich ist in der Figur 3 mit 29 gekennzeichnet und umfaßt z. B. ± zehn Zeilen, was sich in der Praxis als ausreichend herausgestellt hat. Für die Fourierzeilen 1 bis 117 bewirkt ein vom Prozeßrechner 13 angesteuerter Zeilenzähler 25, daß ein Schalter 26 über eine Leitung 27 ein Dauerfreigabesignal erhält, so daß eine von der Atmung unabhängige Meßwerterfassung erfolgt. Nach der Fourierzeile 117 und vor der Fourierzeile 138 ist der Schalter 26 durch den Zeilenzähler 25 über eine Entscheidungslogik 28 in seine gestrichelt gezeichnete Stellung umgelegt, so daß die Meßwerterfassung für die 118. bis 137. Fourierzeile atemphasengesteuert erfolgt. Danach erfolgt die Meßsignalerfassung für die 138. bis 256. Fourierzeile wieder dauernd, also unabhängig von der jeweiligen Atemphase. Die 128. Fourierzeile bildet dabei die Fourier-Nullzeile.

Allgemein wird festgehalten, daß immer auf die Leitung 27, d.h. auf den Frei-Zustand, geschaltet wird, wenn der Zeilenzähler 25 einen Wert zwischen $-\frac{N}{2}$ und A sowie A und $+\frac{N}{2}$ hat, wobei mit N die Matrixzeilenzahl bezeichnet ist. Im Bereich - A... + A ändert sich der Frei-Zustand gemäß dem Atemzyklus (Fig. 5). Da, wie erläutert, in der Praxis nur eine relativ kleine Anzahl von beispielsweise 20 von 256 Fourierzeilen atemphasengesteuert erzeugt werden müssen, wird die Meßzeit im Vergleich zur atemphasengesteuerten Erzeugung aller Fourierzeilen erheblich verkürzt. Trotzdem wird eine hervorragende Artefaktunterdrückung erzielt.

Der vorbestimmte erste Zeilenbereich 29 umfaßt bei dem Ausführungsbeispiel ± 10 % aller gemessenen Fourierzeilen. Er kann fest vorgegeben, aber auch den jeweiligen Bildqualitätserfordernissen entsprechend vorwählbar sein.

Die zweite Ausführungsform beruht auf der Überlegung, daß es nicht zweckmäßig ist, eine ohnehin vorhandene Unschärfe, die aufgrund der Organbewegung zustande kommt, möglichst scharf darzustellen. Es ist also auch im technischen Bereich der Bildzusammensetzung eine dementsprechende Unschärfe zuzubilligen, was wiederum zur Aufnahmezeitverkürzung herangezogen werden kann.

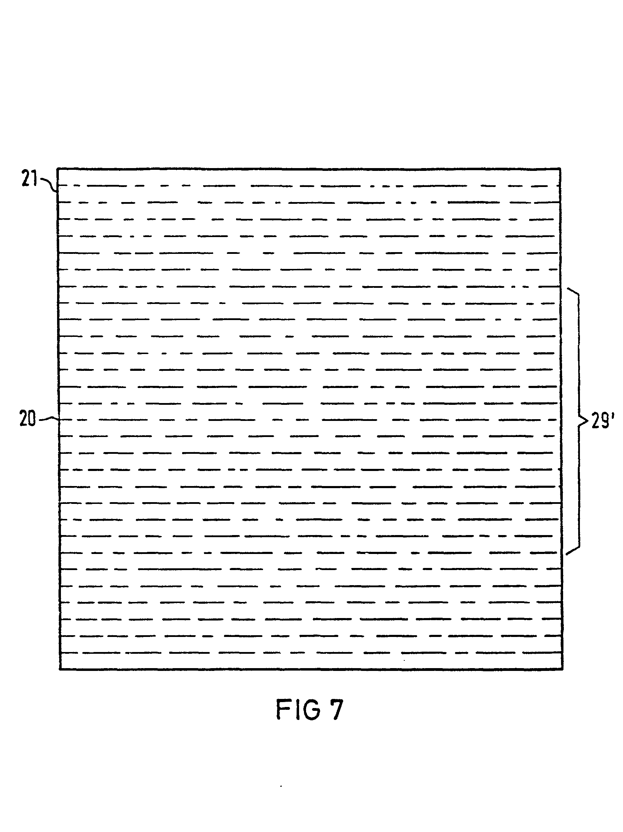

In Figur 6 sind gleiche Teile mit den gleichen Bezugszeichen versehen. Es ist ein Zeilenzähler 25 dargestellt, welcher über eine Verbindungsleitung mit einer Entscheidungslogik 28 verbunden ist. Je nach Stand des Zeilenzählers 25 wird in der Entscheidungslogik 28 entschieden, ob ein Schalter 26 in seine gestrichelte Position oder in seine durchgezogene Position geschaltet ist. Die Entscheidungslogik 28 weist ein Einstellelement 30 auf, mit welchem ein mittlerer Bereich 29', wie in Figur 7 dargestellt, fest eingestellt werden kann. In der Entscheidungslogik 28 wird dann entschieden, ob der Stand des Zeilenzählers 25 innerhalb dieses Bereiches 29' oder außerhalb dieses Bereiches 29' liegt. Befindet sich der Stand des Zeilenzählers 25 innerhalb des Bereiches 29' so wird der Schalter 26 in der gestrichelten Position überführt bzw. wenn er sich dort bereits befunden hat, in dieser Position beibehalten. Ist der Stand des Zeilenzählers 25 außerhalb des Bereiches 29', wird analog hierzu der Schalter 26 in seine durchgezogene Position überführt, bzw. dort gehalten.

In der durchgezogen bezeichneten Position des Schalters 26 wird über eine Leitung 27 an den Prozeßrechner 13 ein Steuersignal gegeben. Bei Anliegen dieses Steuersignals schaltet der Prozeßrechner 13 die Bilddatenerfassung ab und setzt anstelle eines gemessenen Wertes einen synthetischen, vorgebbaren Wert ein. Dieser synthetische Wert kann z. B. weißes Rauschen eine Konstante oder Null sein. Befindet sich der Schalter 26 in seiner gestrichelt gezeichneten Position, so wird der Prozeßrechner 13 über eine Aufbereitungsstufe 24 mit einem Atemphasensignal beaufschlagt. Es erfolgt dann die mit Hilfe der vorherigen Figuren beschriebene atemgesteuerte Meßwerterfassung.

Der am Einstellelement 30 eingestellte Bereich 29' muß nicht notwendigerweise identisch sein mit dem Bereich 29, wie in Figur 3 gezeigt und vorher beschrieben. In dieser Ausführungsform ist es zweckmäßig, den Bereich 29' so zu wählen, daß ca. 50 aller Fourier-Zeilen umfaßt sind. Diese liegen vorzugsweise wiederum in der Mitte der Meßmatrix, was bedeutet, daß beim bevorzugten Beispiel von etwa 50 % und einer Meßmatrix von 256 Zeilen lediglich Meßwerte der Zeilen 64 bis 192 aufgenommen werden. Für die Zeilen 1 bis 63 und 193 bis 256 wird als synthetischer Wert z. B. Null eingesetzt. Es ergibt sich so eine Ersparung an Meßzeit um die Hälfte.

Wie Laborversuche ergeben haben, hat dieses Einsetzen des synthetischen Wertes keine negativen Folgen auf die Bildqualität im Bereich der bewegten Organe. Im Bereich ruhender Objekte wie z. B. der Wirbelsäule, müssen geringe Qualitätsabstriche hingenommen werden. Dieses kann insbesondere dann verkraftet werden, wenn diese ruhenden Objekte nicht Ziel der Untersuchung sind.

Ferner hat sich gezeigt, daß zur Erstellung einer groben Übersichtsaufnahme eine Reduktion der gemessenen Fourier-Zeilen um bis zu 75 % möglich ist. Es werden also nur noch die Fourier-Zeilen 96 bis 160 gemessen, bei den restlichen Fourier-Zeilen wird der synthetische Wert, beispielsweise eine Konstante, eingesetzt.

Vorteil des Gerätes ist, daß der durch die atemgesteuerte Bilddatenerfassung bedingte Zeitverlust ohne nennenswerte Minderung der Bildqualität kompensiert werden kann. Es ist auch denkbar, das Gerät bei nicht-atemgetriggerten Bildaufnahmen einzusetzen, wobei dann bei geringem Qualitätsverlust des Bildes eine erhebliche Verkürzung der Meßzeit erreicht werden kann.

Die beschriebene atemphasengesteuerte Meßsignalerzeugung um die Fourier-Nullzeile herum kann mit einer EKG-Triggerung kombiniert werden.

**Patentansprüche**

1. Gerät zur Erzeugung von Bildern eines Untersuchungsobjektes (2) mit magnetischer Kernresonanz, bei dem Mittel (3) zum Anlegen von magnetischen Grund- und Gradientenfeldern an das Untersuchungsobjekt (2) und zum Erfassen der Auslenkung der Kernspins des Untersuchungsobjektes (2) aus ihrer Gleichgewichtslage durch einen hochfrequenten magnetischen Anregungsimpuls vorhanden sind, wobei bei einer Vielzahl von Gradienten in einer Schicht des Untersuchungsobjektes (2) jeweils eine Projektion der Kernspins auf eine Frequenzachse als Fourierzeile erfaßt und aus den Fourierzeilen ein Bild der jeweils untersuchten Schicht durch Fouriertransformation berechnet wird und wobei Mittel (22, 24) zur Steuerung der Erfassung der Fourierzeilen in Abhängigkeit von einem Bewegungssignal einer Organbewegung vorgesehen sind, gekennzeichnet durch einen Zeilenzähler (25), der Schaltmittel (26) für die Steuerung der Meßsignalerfassung derart ansteuert, daß die Meßsignalerfassung für alle Zeilen außerhalb eines vorbestimmten Bereiches (29) immer, innerhalb dieses Bereiches (29) jedoch in Abhängigkeit vom Bewegungssignal freigegeben wird.

2. Gerät nach Anspruch 1, dadurch gekennzechnet, daß der vorbestimmte Zeilenbereich (29) den Bildqualitätserfordernissen entsprechend vorwählbar ist.

3. Gerät nach Anspruch 1 oder 2, dadurch gekennzeichnet, daß der vorbestimmte Zeilenbereich (29) etwa 10 % aller gemessenen Fourierzeilen umfaßt.

4. Gerät nach Anspruch 2 und 3, dadurch gekennzeichnet, daß der vorbestimmte Zeilenbereich (29) etwa in der Mitte (20) der Meßmatrix liegt.

5. Gerät zur Erzeugung von Bildern eines Untersuchungsobjektes (2) mit magnetischer Kernresonanz, bei dem Mittel (3) zum Anlegen von magnetischen Grund- und Gradientenfeldern an das Untersuchungsobjekt (2) und zum Erfassen der Auslenkung der Kernspins des Untersuchungsobjektes (2) aus ihrer Gleichgewichtslage durch einen hochfrequenten magnetischen Anregungsimpuls vorhanden sind, wobei bei einer Vielzahl von Gradienten in einer Schicht des Untersuchungsobjektes (2) jeweils eine Projektion der Kernspins auf eine Frequenzachse als Fourierzeile erfaßt und aus den Fourierzeilen ein Bild der jeweils untersuchten Schicht durch Fouriertransformation berechnet wird und wobei Mittel (22, 24) zur Steuerung der Erfassung der Fourierzeilen in Abhängigkeit von einem Bewegungssignal einer Organbewegung vorgesehen sind, gekennzeichnet durch einen Zeilenzähler (25), der Schaltmittel (26) für die Steuerung der Meßsignalerfassung derart ansteuert, daß die Meßsignalerfassung für alle Zeilen außerhalb eines vorbestimmten Bereiches (29) abgeschaltet und als Meßsignal ein synthetischer Wert verwendet wird und daß die Meßsignalerfassung innerhalb dieses Bereichs (29) in Abhängigkeit von dem Bewegungssignal freigegeben wird.

6. Gerät nach Anspruch 5, dadurch gekennzechnet, daß der vorbestimmte Zeilenbereich (29) den Bildqualitätserfordernissen entsprechend vorwählbar ist.

7. Gerät nach Anspruch 5 oder 6, dadurch gekennzeichet, daß der vorbestimmte Zeilenbereich (29) etwa 50 % aller gemessenen Fourierzeilen umfaßt.

8. Gerät nach Anspruch 6 und 7, dadurch gekennzeichnet, daß der vorbestimmte Zeilenbereich (29) etwa in der Mitte (20) der Meßmatrix liegt.

**Claims**

1. Device to produce images of an object to be examined (2) by means of nuclear magnetic resonance, means (3) being present for establishing magnetic base and gradient fields on the object to be examined (2), and for determining the deviation of the nuclear spin of the object to be examined (2) from its equilibrium position by means of a high-frequency magnetic excitation impulse, whereby with a plurality of gradients in a layer of the object to be examined (2), a corresponding projection of the nuclear spin is registered on a frequency axis as Fourier line, and an image of the respective layer examined is computed from the Fourier lines by means of Fourier transformation, and whereby means (22, 24) are provided to control the determination of the Fourier lines as a function of a motion signal of an organ movement, characterized by a line counter (25) which triggers a switching device (26) for the control of the collection of measuring signals in such a way that the collection of measuring signals is enabled always for all lines outside a predetermined region (29), but as a function of the motion signal inside this region (29).

2. Device according to claim 1, characterized in that the predetermined line region (29) can be preselected to correspond to the image quality requirements.

3. Device according to claim 1 or 2, characterized in that the predetermined line region (29) comprises about 10 % of all measured Fourier lines.

4. Device according to claim 2 and 3, characterized in that the predetermined line region (29) lies approximately in the middle (20) of the measuring matrix.

5. Device to produce images of an object to be examined (2) by means of nuclear magnetic resonance, means (3) being present for establishing magnetic base and gradient fields on the object to be examined (2), and for determining the deviation of the nuclear spin of the object to be examined (2) from its equilibrium position by means of a high-frequency magnetic excitation impulse, whereby with a plurality of gradients in a layer of the object to be examined (2), a corresponding projection of the nuclear spin is registered on a frequency axis as Fourier line, and an image of the respective layer examined is computed from the Fourier lines by means of Fourier transformation, and whereby means (22, 24) are provided to control the determination of the Fourier lines as a function of a motion signal of an organ movement, characterized by a line counter (25) which triggers a switching device (26) for the control of the collection of measuring signals in such a way that the collection of measuring signals is interrupted for all lines outside a predetermined region (29) and a synthetic value is used as measuring signal, and that the collection of measuring signals within this region (29) is enabled as a function of the motion signal.

6. Device according to claim 5, characterized in that the predetermined line region (29) can be preselected to correspond with the image quality requirements.

7. Device according to claim 5 or 6, characterized in that the predetermined line region (29) comprises about 50 % of all measured Fourier lines.

8. Device according to claim 6 and 7, characterized in that the predetermined line region (29) lies approximately in the middle (20) of the measuring matrix.

**Revendications**

1. Appareil pour produire des images d'un objet à examiner (2), au moyen de la résonance magnétique nucléaire, et dans lequel il est prévu des moyens (3) pour appliquer un champ magnétique de base et des champs magnétiques irrotationnels à l'objet à examiner (2) et pour détecter la déviation des spins nucléaires de l'objet à examiner (2) à partir de leur position d'équilibre, sous l'effet d'une impulsion magnétique d'excitation à haute fréquence, et dans lequel dans le cas d'un grand nombre de gradients présents dans une couche de l'objet à examiner (2), les projections respectives des spins nucléaire sur un axe des fréquences sont détectées en tant que lignes de Fourier, et une image de la couche respectivement examinée est calculée, à partir des lignes de Fourier, au moyen d'une transformation de Fourier, et dans lequel des moyens (22, 24) sont prévus pour commander la détection des lignes de Fourier en fonction d'un signal de déplacement d'un organe, caractérisé par un compteur de lignes (25), qui commande des moyens de commutation (26) servant à commander la détection du signal de mesure de telle sorte que la détection du signal de mesure est toujours déclenchée pour toutes les lignes en dehors d'une zone prédéterminée (29), mais n'est déclenchée à l'intérieur de cette zone (29) qu'en fonction du signal de déplacement.

2. Appareil suivant la revendication 1, caractérisé par le fait que la zone prédéterminée de lignes (29) peut être présélectionnée en fonction des exigences relatives à la qualité de l'image.

3. Appareil suivant la revendication 1 ou 2, caractérisé par le fait que la zone prédéterminée de lignes (29) englobe environ 10 % de toutes les lignes de Fourier mesurées.

4. Appareil suivant les revendications 2 et 3, caractérisé par le fait que la zone prédéterminée de lignes (29) est située approximativement au centre (20) de la matrice de mesure.

5. Appareil pour produire des images d'un objet à examiner (2), au moyen de la résonance magnétique nucléaire, et dans lequel il est prévu des moyens (3) pour appliquer un champ magnétique de base et des champs magnétiques irrotationnels à l'objet à examiner (2) et pour détecter la déviation des spins nucléaires de l'objet à examiner (2) à partir de leur position d'équilibre, sous l'effet d'une impulsion magnétique d'excitation à haute fréquence, et dans lequel dans le cas d'un grand nombre de gradients présents dans une couche de l'objet à examiner (2), les projections respectives des spins nucléaires sur un axe des fréquences sont détectées en tant que lignes de Fourier, et une image de la couche respectivement examinée est calculée à partir des lignes de Fourier, au moyen d'une transformation de Fourier, et dans lequel des moyens (22, 24) sont prévus pour commander la détection des lignes de Fourier en fonction d'un signal de déplacement d'un organe, caractérisé par un compteur de lignes (25), qui commande des moyens de commutation (26) servant à commander la détection du signal de mesure de telle sorte que la détection du signal de mesure est supprimée pour toutes les lignes situées en dehors d'une zone prédéterminée (29) et qu'on utilise une valeur synthétique comme signal de mesure, et que la détection du signal de mesure à l'intérieur de cette zone (29) est déclenchée en fonction du signal de déplacement.

6. Appareil suivant la revendication 5, caractérisé par le fait que la zone prédéterminée de lignes (29) peut être présélectionnée en fonction des exigences relatives à la qualité de l'image.

7. Appareil suivant la revendication 5 ou 6, caractérisé par le fait que la zone prédéterminée de lignes (29) englobe environ 50 % de toutes les lignes de Fourier mesurées.

8. Appareil suivant les revendications 6 et 7, caractérisé par le fait que la zone prédéterminée de lignes (29) est située approximativement au centre (20) de la matrice de mesure.

FIG 1

FIG 2

1

FIG 3

FIG 5

FIG 4

FIG 6

FIG 7